# EUROPEAN PATENT APPLICATION

(11) **EP 4 672 599 A1**
(43) Date of publication of application: **31.12.2025**
(21) Application number: 25178321.3
(22) Date of filing: 22.05.2025
(51) Int. Cl.: H03H 9/02, H03H 9/17, H03H 9/13, H03H 3/02

(54) **ACOUSTIC WAVE RESONATOR WITH THE ACTIVE PIEZOELECTRIC STACK FORMED ABOVE A PLANARIZED REGION AND METHOD FOR MANUFACTURING THE SAME**

(30) Priority: 26.06.2024 TW 113123680
(71) Applicant: Sunrise MEMS Tech Co., Ltd., Taichung City 402 (TW)
(72) Inventor: LO, Yu Chuan, 420013 Taichung City (TW)
(74) Representative: Cabinet Chaillot

(57) **Abstract**

An acoustic wave resonator is disclosed, comprising a substrate (10), a stress-compensating layer (20), an acoustic mirror (30), a lower electrode (33), a piezoelectric stack (40), and an upper electrode (43) sequentially stacked to define an active area (C). The stress-compensating layer (20) includes a planarized region (21) that overlaps the active area (C) and has a surface roughness of less than 5 nm.

## Description

### Field of the Invention

The present invention relates to a resonator, in particular an acoustic wave resonator, and a method of manufacturing the same.

### Background of the Invention

As the demand for high-performance acoustic wave resonators in radio-frequency applications continues to rise, thin-film bulk acoustic resonators (FBARs) have become critical components in communication systems, including 5G technologies. These resonators utilize piezoelectric materials deposited onto silicon wafers or semiconductor substrates to achieve resonance with compact form factors.

However, existing FBAR designs encounter limitations in terms of performance, energy loss, and fabrication efficiency. To address these challenges, further refinements in device architecture and material properties are required to enhance quality factor, minimize loss, and optimize cost-effectiveness.

### Summary of the Invention

The present invention advances FBAR technology by providing an acoustic wave resonator comprising, in sequential order from bottom to top: a substrate, a stress-compensating layer, an acoustic mirror, a lower electrode, a piezoelectric stack, and an upper electrode. The resonator defines an active area where these layers are stacked, and the stress-compensating layer includes a planarized region overlapping this active area, exhibiting a surface roughness of less than 5 nm. A termination area is defined on the remaining area surrounding the active area.

Preferably, the termination area is distributed along the peripheral area of the active area.

Preferably, the substrate possesses material properties conducive to resonator stability, including a low dielectric constant, corrosion resistance, a low thermal expansion coefficient, and high mechanical strength.

Suitable substrate materials include bismaleimide triazine (BT) resin, glass, ceramic, lithium tantalate (LT), and lithium niobate (LN).

Preferably, the stress-compensating layer, which serves as an intermediate layer, has a thickness between 10 nm and 50 µm and can be composed of silicon oxide, silicon nitride, poly-silicon, or multilayered combinations thereof.

Preferably, the stress-compensating layer is structured on the substrate through patterning techniques to enhance device performance.

Preferably, the piezoelectric stack is a metal nitride film characterized by a full width at half maximum (FWHM) value of less than 15 degrees.

This film can be composed of materials such as aluminum nitride (AlN), zinc oxide (ZnO), lead zirconate titanate (PZT), barium strontium titanate (BST), indium nitride (InN), gallium nitride (GaN), or aluminum scandium nitride (AlScN).

The acoustic mirror can be configured as either a cavity or a Bragg reflector.

The invention further discloses a method for manufacturing the acoustic wave resonator, comprising the steps of:
- Provide a substrate;
- Deposit a stress-compensating layer on the substrate;
- Perform a planarization on a portion of the stress-compensating layer to create a planarized region with a surface roughness of less than 5 nm;
- Deposit a lower electrode at least partially overlying the planarized region, with an acoustic mirror formed between the lower electrode and the planarized region;
- Form a piezoelectric stack over at least a portion of the stress-compensating layer and/or the lower electrode, with at least a portion of the piezoelectric stack aligned with the planarized region; and
- Deposit an upper electrode over at least a portion of the piezoelectric stack, with at least a portion of the upper electrode aligned with the planarized region.

By fabricating the acoustic wave resonator directly on the substrate, the present invention significantly reduces material costs relative to conventional silicon-based resonators. Furthermore, the integrated manufacturing approach eliminates the need for post-manufacturing packaging steps. This not only minimizes device size and manufacturing steps, but also enhances thermal dissipation through optimized substrate material selection.

The presence of the planarized region effectively delineates the resonator into the active area and the termination area. This structural configuration not only suppresses vertical acoustic wave leakage through the acoustic mirror within the active area but also mitigates lateral wave leakage via the termination area, thereby enhancing quality factor (Q-factor).

### Brief Description of the Drawings

FIG. 1: Flowchart illustrating the manufacturing process.
FIG. 2: Cross-sectional schematic of a first embodiment.
FIG. 3: Flowchart depicting the first embodiment.
FIG. 4: Cross-sectional schematic of a second embodiment.
FIG. 5: Flowchart depicting the second embodiment.
FIG. 6: Flowchart illustrating a two-step piezoelectric stack deposition process.
FIG. 7: Performance evaluation graph (Smith chart).

### Detailed Description of the Preferred Embodiments

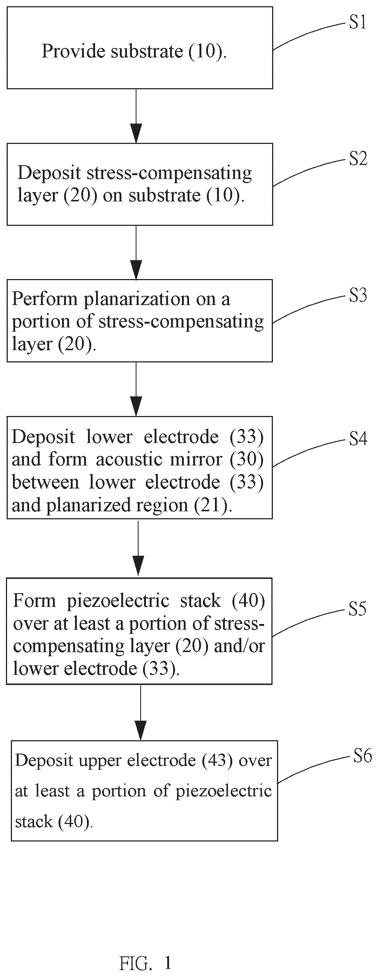

Referring to FIG. 1, the present invention discloses an acoustic wave resonator and a method for manufacturing the same. The acoustic wave resonator is composed of a substrate (10), a stress-compensating layer (20), an acoustic mirror (30), a lower electrode (33), a piezoelectric stack (40), and an upper electrode (43). Upon applying an electrical signal between the lower electrode (33) and the upper electrode (43), the piezoelectric stack (40) undergoes vibration, generating a resonant and anti-resonant frequency response.

The acoustic wave resonator is functionally divided into an active area (C) and a termination area (C1). Within the active area (C), the substrate (10), at least a portion of the stress-compensating layer (20), the acoustic mirror (30), the lower electrode (33), the piezoelectric stack (40), and the upper electrode (43) are vertically stacked. The stress-compensating layer (20) incorporates a planarized region (21) corresponding to the active area (C), exhibiting a surface roughness of less than 5 nm. In contrast, the stress-compensating layer (20) corresponding to the termination area (C1) does not exhibit planar characteristics.

Preferably, the active area (C) is centrally positioned within the acoustic wave resonator, whereas the termination area (C1) is peripherally distributed around the active area (C).

The manufacturing process of the acoustic wave resonator encompasses the following sequential steps:
Step S1: Provide a substrate (10). The substrate (10) is selected based on material properties such as a low dielectric constant, corrosion resistance, a minimal thermal expansion coefficient, and high mechanical strength. Suitable materials include bismaleimide triazine (BT) resin, glass, ceramic, lithium tantalate (LT), or lithium niobate (LN), with ceramic being the preferred substrate material.

A preliminary cleaning procedure may be executed on the substrate (10) prior to subsequent processing steps.

Step S2: Deposit a stress-compensating layer (20) on the substrate (10), with a thickness ranging from 10 nm to 50 µm.

The stress-compensating layer (20) can be composed of silicon oxide, silicon nitride, poly-silicon, or their combinations, and may be implemented as a stacked configuration of these materials. Preferred materials include silicon dioxide (SiO₂), phosphosilicate glass (PSG), or boro-phospho-silicate-glass (BPSG).

Deposition techniques may involve chemical vapor deposition (CVD) or physical vapor deposition (PVD), including pulsed laser deposition (PLD), sputtering, evaporation, or other relevant methods, though the invention is not limited thereto.

The stress-compensating layer (20) may either uniformly cover the entire substrate (10) or be selectively patterned onto the substrate (10).

Step S3: Perform a planarization on a portion of the stress-compensating layer (20) to create a planarized region (21) characterized by a surface roughness of less than 5 nm.

Planarization techniques include ion beam milling, chemical-mechanical planarization (CMP), chemical wet etching, or other equivalent methods, though the invention is not limited thereto.

Step S4: Deposit a lower electrode (33) at least partially overlying the planarized region (21). An acoustic mirror (30) is formed between the lower electrode (33) and the planarized region (21) and extends over the planarized region (21). The acoustic mirror (30) functions as an acoustic wave barrier, mitigating vertical acoustic wave leakage into the substrate (10) and stress-compensating layer (20), thereby minimizing acoustic loss.

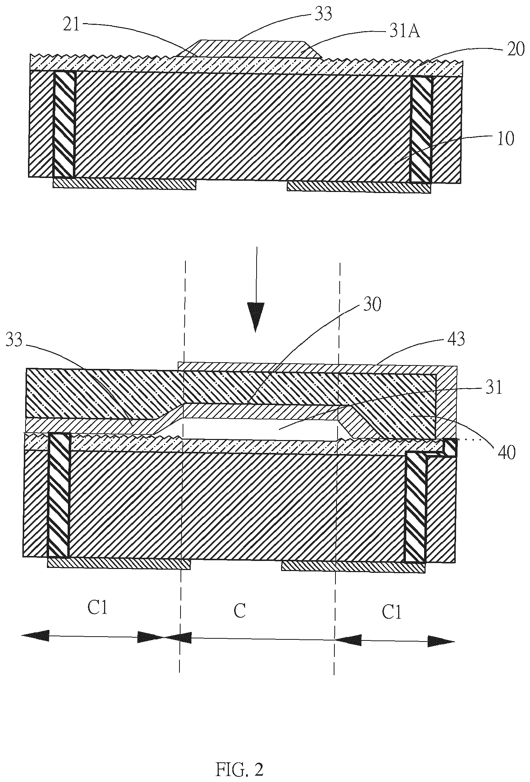

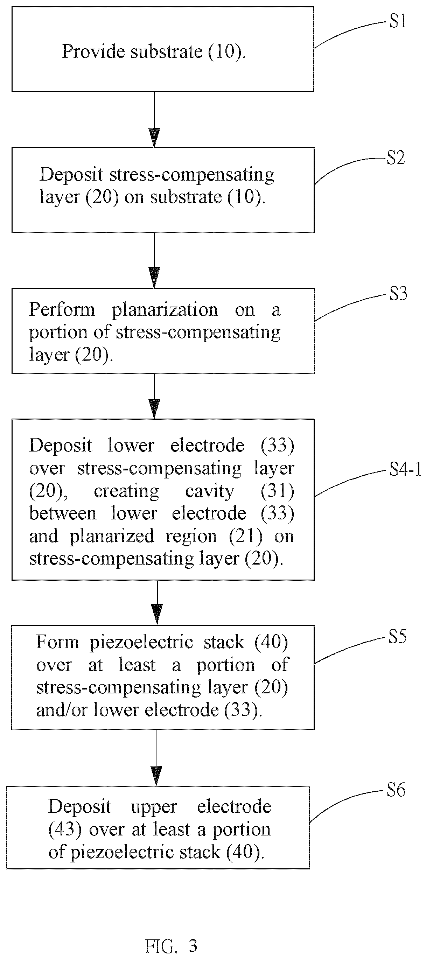

Referring to FIGS. 3 to 5, the acoustic mirror (30) can be configured as either a cavity (31) or a Bragg reflector (32). Consequently, Step S4 is subdivided based on the type of acoustic mirror (30):
Step S4-1: Deposit the lower electrode (33) over the stress-compensating layer (20), creating the cavity (31) between the lower electrode (33) and the planarized region (21) configured on the stress-compensating layer (20), as illustrated in FIGS. 2 and 3.

In one embodiment, the planarized region (21) includes a recess created on the stress-compensating layer (20) during planarization, enabling the lower electrode (33) to be deposited over the recess and define the cavity (31) between the lower electrode (33) and the planarized region (21) configured on the stress-compensating layer (20).

Alternatively, a sacrificial layer (31A) may be initially deposited on the planarized region (21). After deposition of the lower electrode (33), the sacrificial layer (31A) is removed to create the cavity (31).

The sacrificial layer (31A) may comprise binary compound semiconductors (e.g., gallium arsenide), ternary compound semiconductors (e.g., indium gallium phosphide (InGaP), indium gallium arsenide (InGaAs)), quaternary compound semiconductors (e.g., aluminum gallium indium phosphide (AlInGaP)), or equivalent materials.

Additional compositions for the sacrificial layer (31A) may include titanium-tungsten alloy (TiW), copper (Cu), borosilicate glass (BSG), or analogous substances.

Furthermore, the sacrificial layer (31A) may also consist of photoresist materials or alternative polymers, though the invention is not limited thereto.

The material of the sacrificial layer (31A) used must be at least partially different from that of the stress-compensating layer (20) to ensure an etch selectivity ratio between them which allows selective etching (removal of the sacrificial layer (31A)).

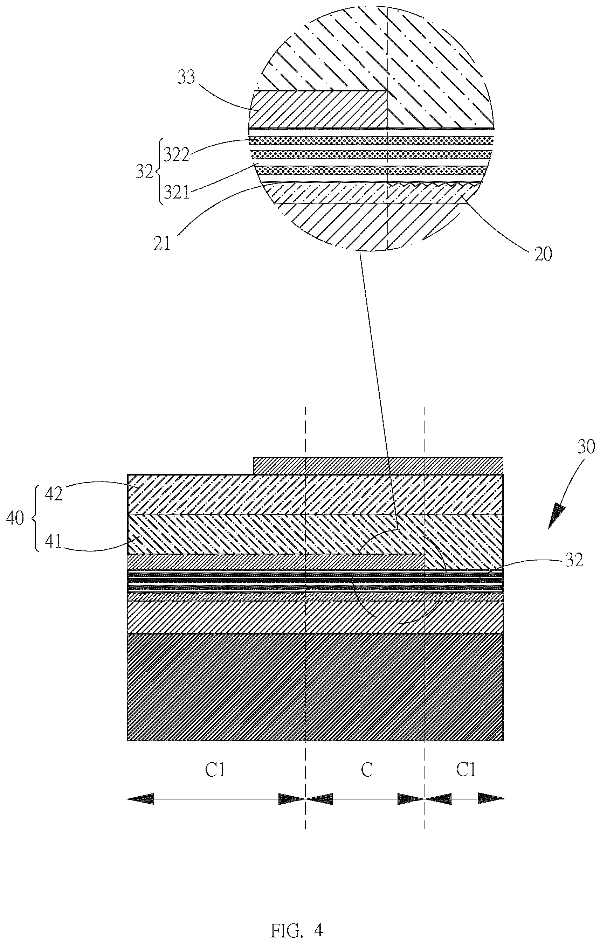

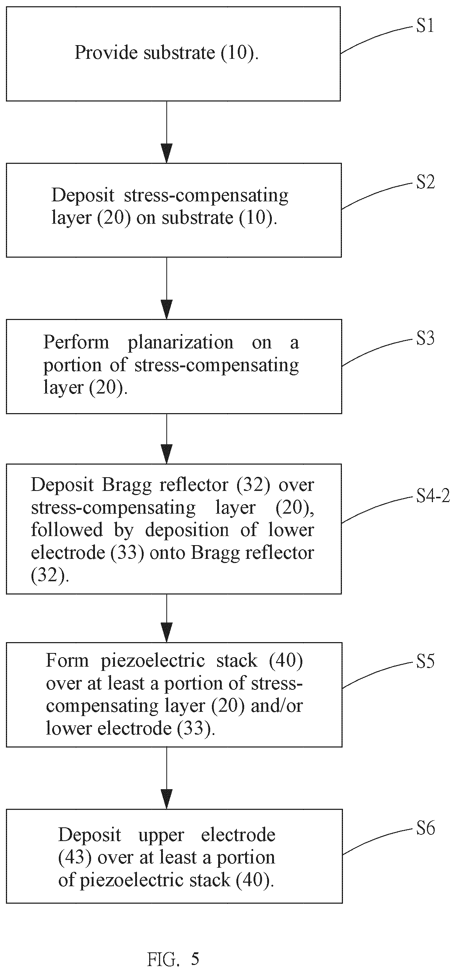

Step S4-2: Deposit the Bragg reflector (32) over the stress-compensating layer (20), followed by the deposition of the lower electrode (33) onto the Bragg reflector (32), ensuring that it is partially aligned with the planarized region (21), as depicted in FIGS. 4 and 5.

The Bragg reflector (32) consists of alternating layers of a high acoustic-impedance layer (321) with a high acoustic impedance and a low acoustic-impedance layer (322) with a comparatively lower acoustic impedance.

This alternating structure facilitates vertical reflection of acoustic waves, mitigating leakage into the substrate (10) and stress-compensating layer (20) below.

The Bragg reflector (32) is fabricated using thin-film deposition techniques, ensuring precise layering of the high acoustic-impedance layer (321) and low acoustic-impedance layer (322).

The subsequent steps are performed as follows:
Step S5: Form a piezoelectric stack (40) over at least a portion of the stress-compensating layer (20) and/or lower electrode (33). The coverage of the piezoelectric stack (40) includes the planarized region (21) as well as non-planarized regions of the stress-compensating layer (20). The piezoelectric stack (40) facilitates the conversion of an electrical energy into mechanical energy in the form of elastic waves via the piezoelectric effect.

The piezoelectric stack (40) comprises a metal nitride film, including but not limited to aluminum nitride (AlN), zinc oxide (ZnO), lead zirconate titanate (PZT), barium strontium titanate (BST), indium nitride (InN), gallium nitride (GaN), and aluminum scandium nitride (AlScN), though the invention is not limited thereto.

The piezoelectric stack (40) exhibits a full width at half maximum (FWHM) value of less than 15 degrees, serving as an indicator of crystallinity.

Deposition of the piezoelectric stack (40) is performed using chemical vapor deposition (CVD) or physical vapor deposition (PVD).

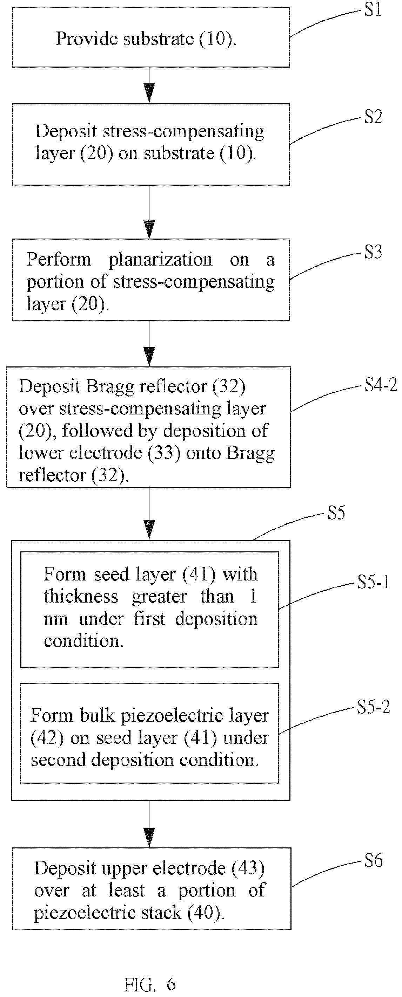

Referring to FIG. 6, the piezoelectric stack (40) may be formed using a two-step deposition process:
Step S5-1: Form a seed layer (41) under a first deposition condition, wherein the seed layer (41) has a thickness greater than 1 nm;
Step S5-2: Form a bulk piezoelectric layer (42) on the seed layer (41) under a second deposition condition.

The first deposition condition has a higher deposition temperature than the second deposition condition. Additionally, the deposition rate and deposition pressure of the first deposition condition are lower than those of the second deposition condition.

Specifically, the first deposition condition is characterized by:
- A deposition rate of less than 100 nm/min;
- A deposition temperature of greater than 100°C; and
- A deposition pressure of less than 0.1 torr.

Preferably, the seed layer (41) covers the active area (C) and is aligned with each other.

Step S6: Deposit an upper electrode (43) over at least a portion of the piezoelectric stack (40), with at least a portion of the upper electrode (43) aligned with the planarized region (21).

Both the lower electrode (33) and the upper electrode (43) are composed of conductive materials, including molybdenum (Mo), ruthenium (Ru), tungsten (W), iridium (Ir), platinum (Pt), copper (Cu), titanium (Ti), tantalum (Ta), nickel (Ni), chromium (Cr), or their respective alloys, though the invention is not limited thereto.

The present invention integrates the acoustic wave resonator directly onto the substrate (10), significantly reducing material costs compared to conventional designs that necessitate silicon (Si) substrates. By implementing wafer-level packaging (WLP), the invention also consolidates fabrication and packaging processes, thereby eliminating the need for post-fabrication encapsulation. This not only streamlines the manufacturing workflow and reduces device dimensions, but also enhances thermal dissipation through optimized substrate (10) material selection.

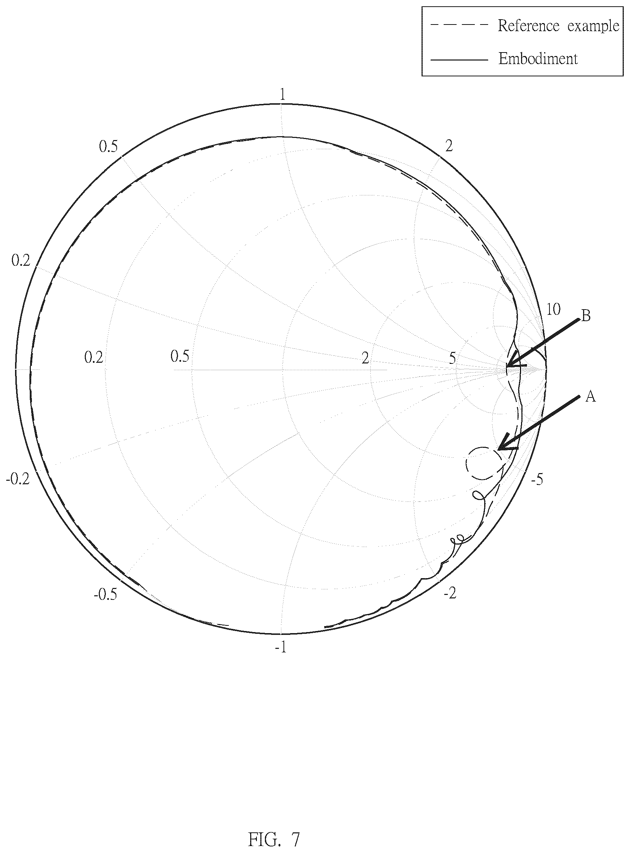

Furthermore, as depicted in the Smith chart of FIG. 7, a comparative performance analysis is conducted between an embodiment of the present invention, wherein the planarized region (21) is formed through selective planarization of the stress-compensating layer (20), and a reference example involving full planarization of the stress-compensating layer (20). The reference example exhibits pronounced spurious modes, as indicated by the loop at arrow A, which signify lateral acoustic wave interference. Conversely, the embodiment of the present invention demonstrates a marked reduction in spurious modes. Moreover, due to these spurious modes, the response curve of the reference example exhibits a dip near the right pole (denoted by arrow B), indicating compromised resonance characteristics. A response curve that extends closer to the right pole corresponds to higher impedance and superior resonant performance. Empirical findings confirm that segmenting the acoustic wave resonator into the active area (C) and the termination area (C1) not only mitigates vertical acoustic wave leakage through the acoustic mirror (30) in the active area (C) but also attenuates lateral wave leakage. This structural optimization enhances the Q-factor, achieved through the planarization of the planarized region (21) and the strategic arrangement of the active area (C) and the termination area (C1).

It should be emphasized that, based on the technical descriptions provided in this specification, those skilled in the art may implement modifications and variations without departing from the core inventive concept. Accordingly, the present invention is not confined to the explicitly disclosed embodiments, and equivalent adaptations fall within the scope of the appended claims. Furthermore, while specific technical terminology is employed for clarity, such terminology should not be construed as imposing limitations on the scope of the invention.

### Reference Signs List

10: Substrate
20: Stress-compensating layer
21: Planarized region
30: Acoustic mirror
31: Cavity
31A: Sacrificial layer
32: Bragg reflector
321: High acoustic-impedance layer
322: Low acoustic-impedance layer
33: Lower electrode
40: Piezoelectric stack
41: Seed layer
42: Bulk piezoelectric layer
43: Upper electrode
C: Active area
C1: Termination area
A, B: Arrows
S1-S6: Process steps

## Claims

1. An acoustic wave resonator comprising, in sequential order from bottom to top: a substrate (10), a stress-compensating layer (20), an acoustic mirror (30), a lower electrode (33), a piezoelectric stack (40), and an upper electrode (43), wherein the resonator defines an active area (C) in which these layers are stacked, the stress-compensating layer (20) includes a planarized region (21) overlapping the active area (C) with a surface roughness of less than 5 nm, and a termination area (C1) is defined on the remaining area surrounding the active area (C).

2. The resonator of claim 1, wherein the termination area (C1) is distributed along the peripheral area of the active area (C).

3. The resonator of claim 2, wherein the substrate (10) exhibits a low dielectric constant, corrosion resistance, a low thermal expansion coefficient, and high mechanical strength.

4. The resonator of claim 3, wherein the substrate (10) is selected from the group consisting of bismaleimide triazine (BT) resin, glass, ceramic, lithium tantalate (LT), and lithium niobate (LN).

5. The resonator of claim 3, wherein the stress-compensating layer (20) has a thickness ranging from 10 nm to 50 µm and is composed of silicon oxide, silicon nitride, poly-silicon, or multilayered combinations thereof.

6. The resonator of claim 5, wherein the stress-compensating layer (20) is patterned on the substrate (10).

7. The resonator of claim 5, wherein the piezoelectric stack (40) is a metal nitride film with a full width at half maximum (FWHM) value of less than 15 degrees.

8. The resonator of claim 7, wherein the metal nitride film is composed of aluminum nitride (AlN), zinc oxide (ZnO), lead zirconate titanate (PZT), barium strontium titanate (BST), indium nitride (InN), gallium nitride (GaN), or aluminum scandium nitride (AlScN).

9. The resonator of any preceding claim, wherein the acoustic mirror (30) is configured as a cavity (31) or a Bragg reflector (32).

10. The resonator of claim 9, wherein the piezoelectric stack (40) comprises a seed layer (41) and a bulk piezoelectric layer (42), with the seed layer (41) covering the active area (C).

11. A method for manufacturing an acoustic wave resonator, comprising the steps of:
provide a substrate (10);
deposit a stress-compensating layer (20) on the substrate (10);
perform a planarization on a portion of the stress-compensating layer (20) to create a planarized region (21) with a surface roughness of less than 5 nm;
deposit a lower electrode (33) at least partially overlying the planarized region (21), with an acoustic mirror (30) formed between the lower electrode (33) and the planarized region (21);
form a piezoelectric stack (40) over at least a portion of the stress-compensating layer (20) and/or the lower electrode (33), with at least a portion of the piezoelectric stack (40) aligned with the planarized region (21); and
deposit an upper electrode (43) over at least a portion of the piezoelectric stack (40), with at least a portion of the upper electrode (43) aligned with the planarized region (21).

12. The method of claim 11, wherein the acoustic mirror (30) is a cavity (31), the steps of depositing the acoustic mirror (30) over the planarized region (21) comprising:
create a recess in the planarized region (21) on the stress-compensating layer (20) during planarization; and
deposit the lower electrode (33) over the recess to define the cavity (31) between the lower electrode (33) and the planarized region (21) configured on the stress-compensating layer (20).

13. The method of claim 11, wherein the acoustic mirror (30) is a cavity (31), the steps of depositing the acoustic mirror (30) over the planarized region (21) comprising:
deposit a sacrificial layer (31A) on the planarized region (21);
deposit the lower electrode (33) over the sacrificial layer (31A); and
remove the sacrificial layer (31A) to create the cavity (31).

14. The method of claim 11, wherein the acoustic mirror (30) is a Bragg reflector (32), the steps of depositing the acoustic mirror (30) over the planarized region (21) comprising:
deposit a Bragg reflector (32) over the stress-compensating layer (20); and
deposit the lower electrode (33) onto the Bragg reflector (32).

15. The method of any of claims 11 to 14, wherein the piezoelectric stack (40) is formed using a two-step deposition process, comprising:
form a seed layer (41) under a first deposition condition, wherein the thickness is greater than 1 nm;
form a bulk piezoelectric layer (42) on the seed layer (41) under a second deposition condition;
wherein the first deposition condition features a higher deposition temperature but a lower deposition rate and deposition pressure than the second deposition condition.

16. The method of claim 15, wherein the first deposition condition is specifically **characterized by**:
a deposition rate of less than 100 nm/min;
a deposition temperature of greater than 100°C; and
a deposition pressure of less than 0.1 torr.
